# EUROPEAN PATENT APPLICATION

(11) **EP 1 073 111 A2**
(43) Date of publication of application: **31.01.2001**
(21) Application number: 00306158.7
(22) Date of filing: 19.07.2000
(51) Int. Cl.: H01L 21/48

(54) **Method and apparatus for forming a solder bump**

(30) Priority: 30.07.1999 JP 21713099
(71) Applicant: Fuji Machine Mfg. Co., Ltd., Chiryu-shi, Aichi-ken (JP)
(72) Inventor: Asai, Koichi, Yama-machi, Chiryu-shi, Aichi-ken (JP)
(74) Representative: Moir, Michael Christopher

(57) **Abstract**

A method of forming one or more solder bumps, including the steps of superposing a mask having one or more through-holes on a substrate having one or more electric circuits, filling the through-holes with creamed solder to apply the creamed solder to the electric circuits, heating the substrate and the mask superposed thereon to form the creamed solder in the one or more through-holes into one or more solder bumps, and removing the mask from the substrate having the solder bump.

## Description

### BACKGROUND OF INVENTION

### Field of Invention

The present invention relates to a method and an apparatus for forming a solder bump and particularly to the art of improving the accuracy with which the solder bump is formed.

### Related Art Statement

A solder bump is formed on, for example, an electric circuit provided on an externally exposed substrate of a so-called "leadless" electric component having no lead wires, so as to provide a terminal of the electric circuit. The leadless electric component is, for example, a package electric component including a container and one or more chip components packed in the container. The solder bump is formed by applying creamed solder to the electric circuit and heating the creamed solder on the circuit. The application of the creamed solder is carried out by, for example, superposing, on the substrate, a stencil mask having one or more through-holes at one or more positions corresponding to one or more bump-form positions on the substrate, moving a squeegee on the stencil mask to move the creamed solder placed on the mask, squeeze the solder against the mask, and force the solder into the through-holes, and thereby applying the solder to one or more electric circuits provided on the substrate. After the application, the stencil mask is removed from the substrate, and the creamed solder thus applied to the substrate is heated to form one or more solder bumps.

However, there has been the problem that the accuracy with which solder bumps are formed is low. For example, in the case where a plurality of solder bumps are formed, on an outer surface of a substrate, at a very small pitch, such as not greater than 0.2 mm, the solder bumps may be formed with shapes and/or dimensions which significantly vary from each other. It can be speculated that this significant variation would result from the facts that the force with which creamed solder is adhered to the substrate is considerably small and that when a stencil mask is removed from the substrate, a force is adversely exerted from the mask to the creamed solder, to peel the solder from the substrate. Thus, the greater the force with which the creamed solder is adhered to the substrate is, and the smaller the force with which the stencil mask peels the creamed solder from the substrate is, the less possible it is that when the mask is removed from the substrate, the solder be peeled from the substrate, and the easier it is for the solder to be separated from the mask. Meanwhile, the peeling force with which the stencil mask peels the creamed solder from the substrate depends on the shape of the through-holes of the mask, and the properties of the material of the mask, such as the roughness of outer surfaces of the mask. However, the shape of the through-holes and the material of the stencil mask strongly depend on a required shape of the mask and required durability and/or workability of the same. Since those requirements cannot be neglected, the peeling force may be comparable to the adhering force. In particular, if solder bumps are formed at a smaller pitch, then the adhering force is smaller whereas the peeling force is greater. Therefore, when the stencil mask is removed from the substrate, a portion of the creamed solder is left in each through-hole, so that solder bumps may be formed with low accuracy of shape and/or dimensions.

### SUMMARY OF INVENTION

It is therefore an object of the present invention to provide a method and an apparatus for forming, on a substrate, solder bumps with high accuracy.

In a first aspect, the present invention provides a method of forming at least one solder bump on a substrate, comprising the steps of:
positioning a mask having at least one through-hole over a substrate,
filling the or each through-hole with a creamed solder to apply the creamed solder to the substrate, and
heating the substrate and the mask to form the creamed solder into at least one solder bump on the substrate, and removing the mask from over the substrate following formation of said at least one solder bump.

According to a preferred embodiment of the present invention, there is provided a method of forming at least one solder bump, comprising the steps of superposing a mask having at least one through-hole on a substrate having at least one electric circuit, filling the through-hole with a creamed solder to apply the creamed solder to the electric circuit, heating the substrate and the mask superposed thereon to form the creamed solder in said at least one through-hole into at least one solder bump, and removing the mask from the substrate having the solder bump. The mask may be a screen mask, a combination mask, or a stencil mask. The substrate on which the solder bumps are formed may be an externally exposed substrate of a leadless, chip-like package electric component, or a printed wiring board on which a plurality of electric components are mounted to provide a printed circuit board. The mask may be removed, either manually or automatically, from the substrate, either immediately after the creamed solder is heated or after the solder bumps are cooled down. Since the substrate and the mask superposed thereon are heated after the creamed solder is applied to the substrate, the creamed solder is melted in one or more through-holes of the mask, and is formed into one or more solder bumps. Since the melted solder is subject to surface tension, the solder does not adhere to the inner surface of each through-hole, and forms a solder bump. In addition, since the solder bump is adhered to the substrate with a great adhering force, the solder bump does not follow the mask when the mask is removed from the substrate after the heating. Thus, one or more solder bumps having a prescribed shape and prescribed dimensions are formed on one or more electric circuits. If the material of the mask and/or the shape of the through-holes of the mask are selected depending on the durability of the mask, the shape of the solder bumps, and the solder-bump-form pitch, solder bumps having a prescribed shape and prescribed dimensions are formed with high accuracy on the substrate.

Preferably, the step of filling the through-hole comprises moving the creamed solder over a surface of the mask while pressing the creamed solder against said surface of the mask to thereby fill the through-hole with the creamed solder.

Alternatively, the step of filling the through-hole comprises placing the creamed solder on the mask, and moving a squeegee over the mask to squeeze the creamed solder into the through-hole of the mask, and thereby fill the through-hole with the creamed solder.

Preferably, the step of heating the substrate and the mask comprises placing the substrate and the mask positioned thereover, in a heating furnace, and heating the substrate and the mask in the heating furnace. The heating furnace may be any one of various known heating furnaces, such as an infrared-light heating furnace, a hot-wind heating furnace, or a nitrogen-gas heating furnace. The heating furnace can simultaneously heat all the creamed solder applied to the substrate. The heating furnace is provided at a position different from the position where the creamed solder is applied to the substrate, and the heating of the creamed solder is carried out after the application of the same. Thus, it is possible to concurrently carry out the application of the creamed solder to a first substrate and the heating of the same on a second substrate. However, it is not essentially required to employ the heating furnace. For example, it is possible to employ a heating device which can heat, at once, only an area smaller than the area of each substrate. In this case, the heating device and each substrate are moved relative to each other to heat the entire area of each substrate. As will be described in DETAILED DESCRIPTION OF PREFERRED EMBODIMENTS, it is possible to concurrently carry out the application and heating of the creamed solder to and on each substrate. Otherwise, it is possible to heat the creamed solder after the application of the creamed solder to each substrate is completely finished. In the former case, an applying device and a heating device are provided at a same place, whereas in the latter case, the two devices are provided at either a same place or different places. In the case where the two devices are provided at a same place, the mask can be used commonly for a plurality of substrates, which contributes to reducing the cost of formation of solder bumps. In the case where the two devices are provided at different places, it is needed to move, after the application of the creamed solder, each substrate and the mask superposed thereon from the solder-apply place to the solder-heat place, so as to heat the mask superposed on the substrate. Thus, in the last case, the mask cannot be kept at the solder-apply position. In contrast thereto, if the application and the heating are carried out at a same place, the mask can be removed from the substrate on which the heating of the creamed solder has been finished and can be kept at the solder-apply place that is also the solder-heat place, and only the substrate can be carried out from the same place. In the case where the application and heating of the creamed solder to and on each substrate are concurrently carried out, solder bumps can be quickly formed on the substrate. However, even in the case where the application and the heating are carried out at a same place, it is possible to carry out each substrate from the same place without removing the mask from the substrate and subsequently remove the mask from the substrate at an outside place.

Alternatively, the step of heating the substrate and the mask comprises irradiating an electromagnetic wave toward at least the through-hole of the mask positioned over the substrate, and thereby melting the creamed solder in the through-hole. The electromagnetic wave may be an infrared light, a visible light, a laser beam, or an electron beam.

Preferably, the mask is formed of a material which has a lower wettability with respect to the creamed solder than a wettability of the substrate with respect to the creamed solder. The mask may be formed of, e.g., stainless steel as one of metals whose wettability with respect to the creamed solder is low. The mask formed of stainless steel is a sort of stencil mask. In the solder-bump forming method according to this feature, the solder bumps do not adhere to the mask and, when the mask is removed from the substrate after the formation of the bumps, the bumps are more effectively prevented from following the mask.

A second aspect of the present invention provides apparatus for forming at least one solder bump, comprising:
means for positioning a mask having at least one through-hole, over a substrate;
means for filling the or each through-hole of the mask with a creamed solder to apply the creamed solder to the substrate; and
means for heating at least the creamed solder in the through-hole of the mask while the mask is positioned over the substrate to form at least one solder bump on the substrate.

According to a preferred embodiment of the present invention, there is provided an apparatus for forming at least one solder bump, comprising a positioning device which positions a mask having at least one through-hole, relative to a substrate, in a state in which the mask is superposed on the substrate; an applying device which fills the through-hole of the mask with a creamed solder and thereby applies the creamed solder to the substrate; and a heating device which heats at least the creamed solder in the through-hole of the mask in the state in which the mask is superposed on the substrate. When the applying device applies the creamed solder to the substrate, the applying device may be moved relative to the substrate, the substrate may be moved relative to the applying device, or the two elements may be moved relative to each other in opposite directions, respectively. Otherwise, the creamed solder may be applied to the substrate without moving the substrate and the applying device relative to each other. The heating device may be one which simultaneously heats all portions of the substrate, one which heats, at once, only a portion of the substrate that includes at least one through-hole, or one which heats, at once, only each solder bump. The present solder-bump forming apparatus enjoys the advantages of the solder-bump forming method in accordance with the first aspect.

Preferably, the applying device comprises a pressing and applying device which moves the creamed solder on one of opposite surfaces of the mask while pressing the creamed solder against said one surface of the mask that is opposite to the other surface thereof on a side of the substrate, and thereby fills the through-hole with the creamed solder to apply the creamed solder to the electric circuit.

Preferably, the applying device comprises a squeegee which squeezes the creamed solder placed on the mask, into the through-hole of the mask, and thereby fills the through-hole with the creamed solder to apply the creamed solder to the electric circuit.

Preferably, the heating device comprises a heating furnace which heats the substrate and the mask superposed thereon.

Preferably, the heating device comprises an irradiating device which irradiates an electromagnetic wave toward at least the through-hole of the mask superposed on the substrate, and thereby melts the creamed solder in the through-hole.

### BRIEF DESCRIPTION OF DRAWINGS

The above and optional objects, features, and advantages of the present invention will be better understood by reading the following detailed description of the preferred embodiments of the invention, when considered in connection with the accompanying drawings, in which:
Fig. 1 is a front elevation view of a solder-bump forming apparatus as a first embodiment of the present invention;
Fig. 2 is a cross-sectioned front elevation view of a pressing-and-applying head of an applying device as an element of the solder-bump forming apparatus of Fig. 1;
Fig. 3 is a perspective view of a substrate on which solder bumps are formed by the solder-bump forming apparatus of Fig. 1, and a stencil mask which is used to form the solder bumps;
Fig. 4 is a partly cross-sectioned front elevation view showing the manner in which creamed solder is applied to the substrate by the applying device of the solder-bump forming apparatus of Fig. 1;
Fig. 5 is a partly cross-sectioned front elevation view showing the creamed solder applied to the substrate by the applying device of the solder-bump forming apparatus of Fig. 1;
Fig. 6 is a front elevation view showing the solder bumps with the stencil mask being removed from the substrate;
Fig. 7 is a perspective view of a printed wiring board on which solder bumps are formed by another solder-bump forming apparatus as a second embodiment of the present invention, and a stencil mask;
Fig. 8 is cross-sectioned front elevation view of a squeegee head of an applying device as an element of another bump-forming apparatus as a third embodiment of the present;
Fig. 9 is a partly cross-sectioned front elevation view showing the manner in which creamed solder is applied to a substrate by the squeegee head of Fig. 8; and
Fig. 10 is a partly cross-sectioned front elevation view of another solder-bump forming apparatus as a fourth embodiment of the present invention.

### DETAILED DESCRIPTION OF PREFERRED EMBODIMENTS

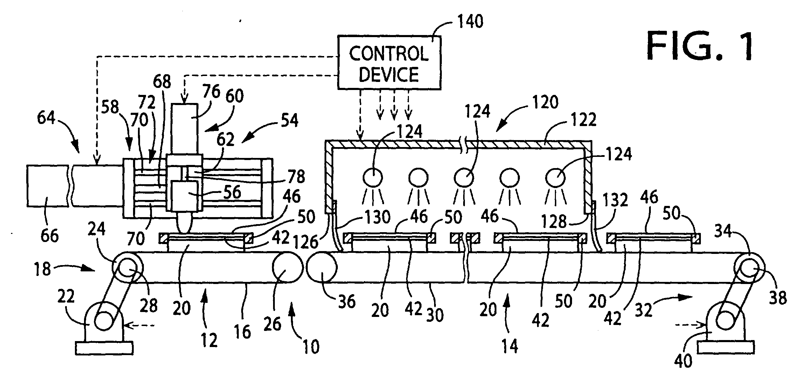

Referring first to Figs. 1 to 6, there will be described a solder-bumper forming apparatus embodying the present invention, with respect to a case where the apparatus is used for forming solder bumps on a surface of an exposed substrate of a package electric component 20 having no lead wires.

In Fig. 1, reference numeral 10 designates a substrate conveying device. In the present embodiment, the substrate conveying device 10 includes two belt conveyors 12, 14 which are provided in series. The belt conveyor 12 includes a pair of endless, annular conveyor belts 16 (only one belt 16 is shown in Fig. 1) each as a wound-on member. In the present embodiment, the conveyor belts 16 extend horizontally and, when the belts 16 are circulated by a belt drive device 18, the package electric component 20 is conveyed in a horizontal direction. In the present embodiment, the conveyor belts 16 are each a so-called "V-belt" having a V-shaped cross section.

The belt drive device 18 includes a servomotor 22 that is an electric rotary motor as a sort of drive source. The servomotor 22 is controllable with respect to its rotation angle or amount. The two conveyor belts 16 are spaced from each other in a horizontal direction perpendicular to a substrate-feed direction in which the electric component 20 is conveyed, and each belt 16 is wound on a drive pulley 24 and a driven pulley 26 each as a rotary wheel that is rotatable about a horizontal axis line perpendicular to the substrate-feed direction. The drive and driven pulleys 24, 26 are each a so-called "V-pulley" having a V-shaped groove. The two drive pulleys 24 on which the two belts 16 are wound have a common axis member 28 and, when the common axis member 28 is rotated by the servomotor 22, the two drive pulleys 24 are rotated, so that the two belts 16 are circulated in synchronism with each other at the same speed.

Between the two conveyor belts 16, there is provided a positioning and fixing device which positions and fixes the electric component 20 at and to a solder-apply position. Since the positioning and fixing device is well known in the art, the description and illustration thereof are omitted. The positioning and fixing device positions and fixes the electric component 20 at the applying position, such that the component 20 takes a horizontal posture.

The belt conveyor 14 has a construction similar to that of the belt conveyor 12. In short, the belt conveyor 14 includes a pair of endless, annular conveyor belts 30 (only one belt 30 is shown in Fig. 1) that are spaced from each other in a horizontal direction perpendicular to the substrate-feed direction, and a belt drive device 32. Each of the two conveyor belts 30 is wound on a drive pulley 34 and a driven pulley 36 each as a rotary wheel, and when a common axis member 38 is rotated by a servomotor 40, the two conveyor belts 30 are circulated in synchronism with each other at the same speed. The drive and driven pulleys 34, 36 are each a V-pulley. However, the belt conveyors 12, 14 are not limited to V-belts, but may be provided by, e.g., round belts, flat belts, or timing (or cog) belts. The rotary wheels on which the conveyor belts are to be wound are so selected as to correspond to the sort of the belts employed.

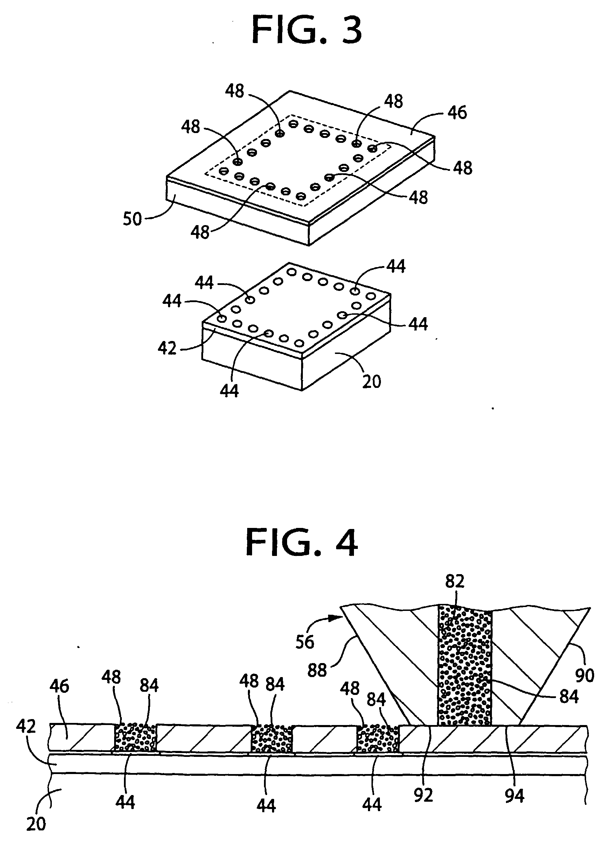

The electric component 20 is a so-called "leadless" electric component having no leads. As shown in Fig. 3, the electric component 20 includes an externally exposed substrate 42, and a plurality of electric circuits 44 provided on an outer surface of the substrate 42. A stencil mask 46 as a sort of mask is superposed on, and fixed to, the outer surface of the substrate 42 on which the electric circuits 44 are provided. The stencil mask 46 is formed of stainless steel as a sort of material whose wettability with respect to creamed solder is lower than that of the electric circuits 44, and has a plurality of through-holes 48 formed through the thickness thereof at respective positions corresponding to the electric circuits 44 provided on the substrate 42. In the present embodiment, the electric circuits 44 are formed at a very small pitch, e.g., 0.2 mm, and the through-holes 48 are formed at the same pitch.

As shown in Figs. 1 and 3, the stencil mask 46 is supported and held by a frame 50. The frame 50 is detachably attached to the electric component 20, in a state in which the stencil mask 46 is positioned relative to the substrate 42 such that the through-holes 48 of the mask 46 are aligned with the corresponding electric circuits 44 of the substrate 42. In the present embodiment, the frame 50 provides a positioning device. In Fig. 1, the stencil mask 46 is spaced from the substrate 42, for illustration purposes only. The stencil mask 46 superposed on the substrate 42 is, in fact, in contact with the substrate 42.

As shown in Fig. 1, an applying device 54 is provided above the first belt conveyor 12. The applying device 54 includes a pressing and applying head 56, a head moving device 58, and a head elevating and lowering device 60. The head moving device 58 includes a movable member 62 which is movable in a direction parallel to the substrate-convey direction, and a movable-member drive device 64. The drive device 64 includes an air-operated cylinder device 66 as its drive source, and a piston rod 68 fixed to the movable member 62. When the piston rod 68 is extended and retracted, the movable member 62 is moved in directions parallel to the substrate-convey direction by being guided by a pair of guide rails 70 as part of a guide device 72.

The head elevating and lowering device 60 is provided on the movable member 62. The elevating and lowering device 60 includes an air-operated cylinder device 76 which is oriented downward and which includes a piston rod 78 to which the pressing and applying head 56 is fixed. When the piston rod 78 is extended and retracted, the pressing and applying head 56 is lowered and elevated by being guided by a guide device (not shown). When the movable member 62 is moved, the head 56 is moved in directions parallel to the substrate-convey direction along the substrate 42 and the mask 46 and, when the piston rod 78 is moved, the head 56 is lowered and elevated on the movable member 62, so that the head 56 is moved toward, and away from, the substrate 42 and the mask 46. Hereinafter, the directions parallel to the substrate-convey direction will be referred to as the "solder-apply" direction. The head elevating and lowering device 60 can be called as a device which moves the applying head 56 toward, and away from, the substrate 42 and the mask 46 superposed on the substrate 42. The head 56 is accurately located, relative to the electric circuits 44 of the substrate 42 positioned and fixed at the solder-apply position, in a horizontal direction parallel to the substrate 42 and perpendicular to the substrate-convey direction (hereinafter, referred to as the "widthwise" direction of the substrate 42), such that the head 56 can apply the creamed solder to each of the electric circuits 44 of the substrate 42.

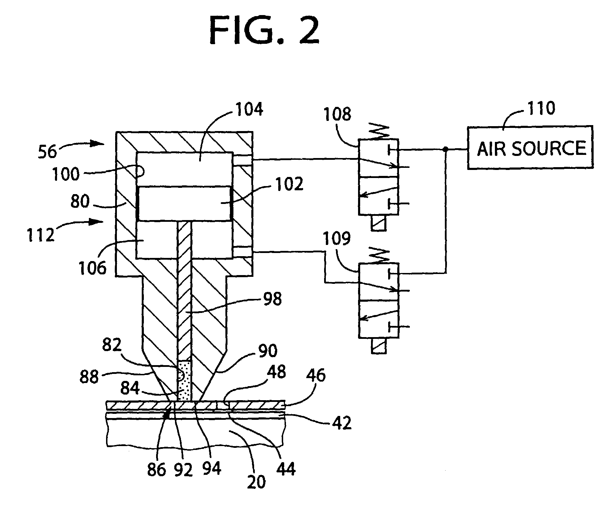

As shown in Fig. 2, the pressing and applying head 56 includes a housing 80 having a creamed-solder store room 82 in which creamed solder 84 is stored. As described previously, in the present embodiment, the pitch at which the electric circuits 44 are provided on the substrate 42, that is, solder bumps 144 are to be formed on the electric circuits 44 is 0.2 mm. The creamed solder 84 contains solder particles whose diameter is not greater than 10 µm, and has a high thixotropy. The store room 82 has, in the widthwise direction of the substrate 42, a length which assures that the head 56 can simultaneously apply the creamed solder 84 to each of the electric circuits 44 arranged in the widthwise direction. The store room 82 opens in a lower surface 86 of the housing 80. The housing 80 has, on both sides of the lower surface 86 in the solder-apply direction, two inclined surfaces 88, 90 which are inclined such that as the surfaces 88, 90 extend downward, the surfaces 88, 90 approach each other. The lower surface 86 includes, on both sides of the store room 82 in the solder-apply direction, two press surfaces 92, 94 which are continuous with the inclined surfaces 88, 90, respectively, and which are horizontal and short in the solder- apply direction.

The pressing and applying head 56 further includes a press plate 98 as a press member that fits in the creamed-solder store room 82 such that the press plate 98 is vertically movable. In the present embodiment, the press plate 98 has a flat shape having a constant thickness, and has dimensions which assure that the plate 98 is vertically movable in the store room 82 and is fitable in the room 82 such that substantially no spaces are left in the solder-apply direction or in the direction of movement of the head 56. Two upper end portions of the press plate 98 project into two cylinder bores 100, respectively, which are provided above the store room 82 and are arranged in the horizontal direction perpendicular to the solder-apply direction. Each of the two upper end portions of the press plate 98 is vertically movable in a corresponding one of the two cylinder bores 100.

A piston 102 fits in each of the two cylinder bores 100, such that the piston 102 is vertically movable. The two upper end portions of the press plate 98 which project into the two bores 100 are fixed to the two pistons 102, respectively. Each of the cylinder bores 100 has, both sides of the piston 102 in the vertical direction, two air chambers 104, 106 which are connected to two solenoid-operated switch valves 108, 109, respectively. When each of the two air chambers 104, 106 of each bore 100 is selectively communicated with an air source 110 or the atmosphere via a corresponding one of the two switch valves 108, 109, the piston 102 is vertically moved, so that the press plate 98 is lowered and elevated. Thus, the two pistons 102 and the two cylinder bores 100 cooperate with each other to provide two air-operated cylinder devices 112 each as a press-member drive device that moves the press member 98 and thereby presses the creamed solder 84 against the stencil mask 46 superposed on the substrate 42. The two switch valves 108, 109 are commonly used by the two air-operated cylinder devices 112. However, in the case where the substrate 42 has a small dimension (i.e., a small width) in the horizontal direction perpendicular to the solder-apply direction, the head 56 may employ only one air-operated cylinder device 112.

As shown in Fig. 1, an infrared-light heating furnace 120 as a heating device is provided above the second belt conveyor 14. The heating furnace 120 includes a plurality of infrared-light lamps 124 which are provided in a housing 122. The housing 122 has an inlet 126 on the side of the applying device 54, and an outlet 128 remote from the applying device 54 in the substrate-convey direction. Two curtains 130, 132 are provided at the inlet 126 and the outlet 128, respectively, and each of the curtains 130, 132 is opened and closed at respective appropriate timings when the electric component 20 is conveyed by the conveyor belt 14. The belt conveyor 14 and the heating furnace 120 have, in the substrate-convey direction, respective lengths which assure that a plurality of electric components 20 are simultaneously heated.

The present solder-bump forming apparatus is controlled by a control device 140 shown in Fig. 1. The control device 140 is essentially provided by a computer including a processing unit ("PU"), a read only memory ("ROM"), a random access memory ("RAM"), and a bus connecting between those elements. The control device 140 controls the servomotors 22, 40, the air cylinders 66, 76 (more accurately, solenoid-operated control valves which controls the supplying of air to the cylinders 66, 76), the solenoid-operated switch valves 108, 109, and the infrared-light lamps 124 of the infrared-light heating furnace 124. Each of the air-operated cylinder devices 66, 76, 112 is a sort of pressurized-fluid-operated cylinder device as a sort of pressurized-fluid-operated actuator as a sort of drive source.

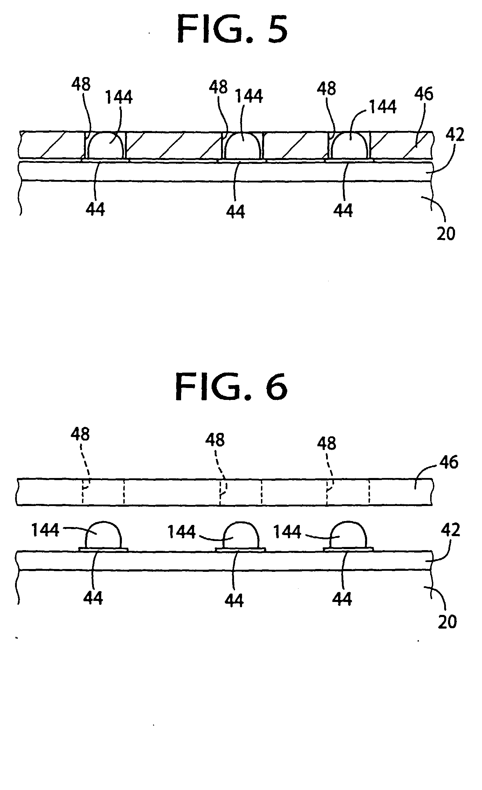

When the solder-bump forming apparatus constructed as described above is used to form solder bumps 144 (Fig. 5) on the substrate 42, first, the stencil mask 46 is superposed on, and fixed to, the substrate 42 of the electric component 20, and then the electric component 20 is placed on the conveyor belts 16 of the first belt conveyor 12, by a placing device (not shown). Subsequently, the electric component 20 is moved to the solder-apply position. At this time, the pressing and applying head 56 of the applying device 54 is kept at an upper-dead position thereof where the head 56 allows the electric component 20 to be moved to the solder-apply position. Since the electric component 20 is positioned and fixed at the solder-apply position by the positioning and fixing device (not shown), the substrate 42 and the stencil mask 46 are positioned and fixed at the solder-apply position. In this state, the head 56 is lowered to press the press surfaces 92, 94 against the mask 46. After the press surfaces 92, 94 are pressed against the mask 46, the press plate 98 is lowered by the air cylinders 112, so that a pressing force is applied to the creamed solder 84. Since the head 56 is pressed against the mask 46 and the lower opening of the creamed-solder store room 82 is closed by the stencil mask 46, the creamed solder 84 does not come out of the store room 82, and an appropriate pressing force is applied by the press plate 98 to the creamed solder 84 stored in the store room 82.

When the pressing and applying head 56 is moved by the head moving device 58 along the substrate 42 of the electric component 20, the creamed solder 84 stored in the store room 82 is prevented from coming out of the store room 82, by a downstream-side one of the two press surfaces 92, 94 as seen in the solder-apply direction, and is scraped from an upper surface of the stencil mask 46 by an upstream-side one of the press surfaces 92, 94. Thus, the creamed solder 84 is kept in the store room 82 and, as the head 56 is moved in the solder-apply direction, the creamed solder 84 is moved on the upper surface of the stencil mask 46 while being pressed against the upper surface of the mask 46 that is opposite to a lower surface thereof on the side of the substrate 42. As shown in Fig. 4, each time the opening of the creamed-solder store room 82 faces one through-hole 48 of the mask 46, an appropriate amount of creamed solder 84 is pressed into that through-hole 48 and is applied or adhered to the electric circuit 44. Since an excessive amount of creamed solder 84 is scraped by the upstream-side press surface 92 or 94, each through-hole 48 is just filled with the creamed solder 84. This step is a creamed-solder applying step or a through-hole filling step.

After the creamed-solder applying step, the pressing and applying head 56 is elevated and is moved away from the stencil mask 46. More specifically described, the two air chambers 104, 106 of each air cylinder 112 are communicated with the atmosphere, and the head 56 is moved in a horizontal direction by the head moving device 58 while being elevated by the air cylinder 76. Thus, a portion of the creamed solder 84 that is, in the store room 82, in contact with the stencil mask 46 is scraped from the mask 46 by an upstream-side one of the two press surfaces 92, 94 as seen in the direction of movement of the head 56. In addition, because of its viscosity, the creamed solder 84 follows the housing 80 being elevated, so that the head 56 is moved away from the mask 46 without any creamed solder 84 left on the upper surface of the mask 46.

After the pressing and applying head 56 is moved away from the stencil mask 46, the positioning and fixing device (not shown) releases the electric component 20 and subsequently the first belt conveyor 12 is operated, so that the electric component 20 and the mask 46 superposed on the substrate 42 of the component 20 are moved toward an end of the conveyor 12 on the side of the infrared-light heating device 120. When the substrate 42 reaches the heating-device-side end of the conveyor 12 and a downstream-side end of the substrate 42 is transferred from the first conveyor 12 to the second conveyor 30, the second conveyor 30 is operated to move the substrate 42. Since the second conveyor 14 is operated to move the electric component 20 at the same speed as that at which the first conveyor 12 moves the component 20, the component 20 can be smoothly transferred from the first conveyor 12 to the second conveyor 14, and is conveyed into the housing 122 of the infrared-light heating device 120. Since the heating device 120 is always in an operating or heating state, the electric component 20 and the stencil mask 46 superposed on the substrate 42 of the component 20 are heated in the housing 122 of the heating device 120. This step is a heating step. Concurrently with the conveying of the substrate 42, on which the application of the creamed solder 84 has been finished, toward the heating device 120, another electric component 20 is supplied to the first belt conveyor 12, so that the component 20 is conveyed to the solder-apply position where the creamed solder 84 is applied to the substrate 42 of the component 20. However, it is possible that after the electric component 20 whose substrate 42 has been subjected to the application of the creamed solder 84 enters the heating device 120, another electric component 20 be supplied to the first belt conveyor 12.

The infrared-light heating device 120 has a size which assures that a plurality of electric components 20 are simultaneously heated and, each time one electric component 20 enters the heating device 120, another component 20 exits the device 120. To this end, it is possible that the second belt conveyor 14 be intermittently operated or moved at a regular pitch which is controlled by the control device 140. In the present embodiment, however, a stopper (not shown) is provided in the vicinity of the outlet 128 of the heating device 120, such that the stopper is movable to an operative position where the stopper stops the most downstream one of the electric components 20 currently present in the housing 122, at a position near the outlet 128 and inside the housing 122, and to an inoperative position away from the operative position.

The electric component 20 and the stencil mask 46 superposed thereon are heated during a time after the component 20 enters the infrared-light heating furnace 120 and before the component 20 exits the same 120. Thus, the creamed solder 84 present in the through-holes 48 of the mask 46 is melted, so that solder bumps 144 are formed as shown in Fig. 5. Since the stencil mask 46 is formed of a material (e.g., stainless steel) whose wettability with respect to the solder is lower than that of the electric circuits 44, the solder does not adhere to the mask 46. In addition, the melted solder is subjected to surface tension. Thus, the solder does not adhere to the inner surface of each through-hole 48, and a semi-spherical solder bump 144 is formed in each through-hole 48. After the heating, the electric component 20 is moved out of the heating furnace 120 by the second belt conveyor 14 and subsequently the stencil mask 46 is removed from the substrate 42 as shown in Fig. 6. The removing of the mask 46 from the substrate 42 may be performed on the conveyor belts 30. Alternatively, it is possible to remove the mask 46 from the substrate 42 after both the substrate 42 and the mask 46 superposed thereon are unloaded from the conveyor belts 30 and the solder bumps 144 are cooled down. Otherwise, after the solder bumps 144 are cooled down on the belts 30, the mask 46 may be removed from the substrate 42. It is possible to employ the conveyor belts 30 which have a length which allows the belts 30 to continue conveying the electric component 20 till the solder bumps 144 cool down. The removing of the mask 46 from the substrate 42 may be performed by an operator, or by an automatic mask removing device (not shown). This step is a mask removing step. In either case, each solder bump 144 is formed in the through-hole 48, away from the inner surface thereof, and is adhered to the electric circuit 44 with a great force. Therefore, when the mask 46 is removed from the substrate 42, the solder bumps 144 do not follow the mask 46. Thus, a plurality of solder bumps 144 each having prescribed dimensions and a prescribed shape are accurately formed at a prescribed pitch on the substrate 42. When the head 56 applies the creamed solder 84 to the next or second substrate 42, the head 56 is moved in a direction opposite to the direction in which the head 56 is moved to apply the solder 84 to the first substrate 42.

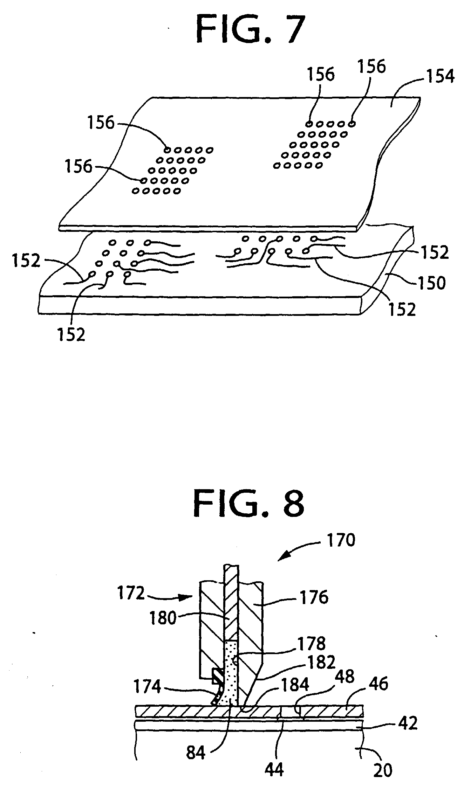

In the first embodiment shown in Figs. 1 to 6, the solder bumps 144 are formed on the substrate 42 as part of the leadless electric component 20. However, solder bumps may be formed on a printed wiring board 150 as a substrate, as shown in Fig. 7.

Fig. 7 shows the printed circuit board 150 which has a number of electric circuits 152 on which respective solder bumps are to be formed. To this end, a stencil mask 154 has a number of through-holes 156 at respective positions corresponding to respective solder-bump-form positions on the board 150. The holes 156 are formed through the thickness of the mask 154. Like the stencil mask 46, the stencil mask 154 is supported by a frame (not shown), and is detachably attached to the board 150 such that the frame fits on the board 150 and accordingly the mask 154 is positioned relative to the board 150 so that the through-holes 156 of the mask 154 are aligned with the solder-bump-form positions of the board 150. Thus, the frame (not shown) provides the positioning device.

The printed wiring board 150 is greater than the leadless electric component 20 shown in Fig. 3. Therefore, the solder-bump forming apparatus which forms solder bumps on the printed wiring board 150 has a construction similar to that of the solder-bump forming apparatus shown in Fig. 1, but employs dimensions and shapes corresponding to those of the board 150. Since the present apparatus as the second embodiment of the present invention applies the creamed solder 84 to the printed wiring board 150, and heats the creamed solder 84 in the through-holes 156 of the stencil mask 154, like the apparatus shown in Fig. 1, the description thereof is omitted.

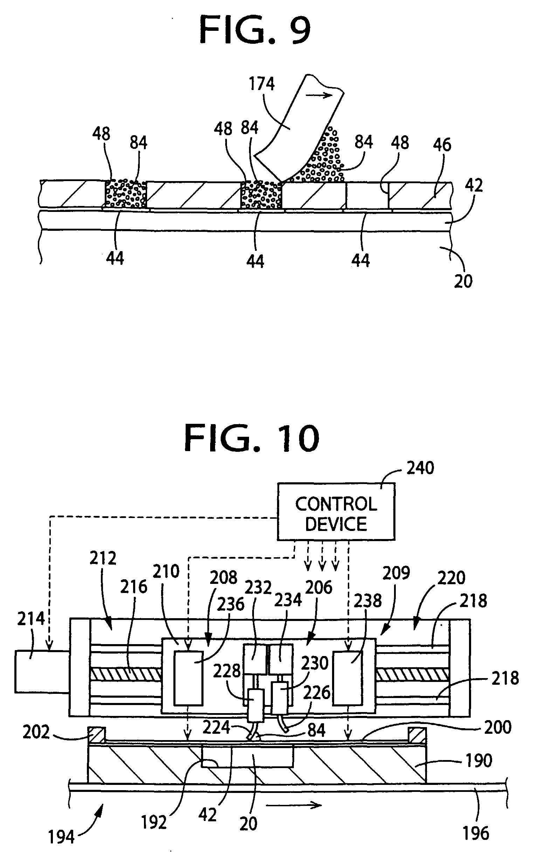

Figs. 8 and 9 show a third embodiment of the present invention that relates to a solder-bump forming apparatus which employs an applying device 170 including a squeegee 174. The present apparatus applies the creamed solder 84 to the substrate 42 of the leadless electric component 20, like the apparatus shown in Fig. 1. The applying device 170 includes a squeegee head 172 which is moved, like the pressing and applying head 56 employed in the first embodiment, by a head moving device (not shown), along the stencil mask 46 in opposite directions parallel to the substrate-convey direction, and is lowered and elevated by a head elevating and lowering device (not shown) so as to be moved toward, and away from, the mask 46.

The squeegee head 172 includes a housing 176 having a creamed-solder store room 178 in which the creamed solder 84 is stored. A press plate 180 fits in the store room 178 such that the press plate 180 is vertically movable, and is vertically moved by one or more air-operated cylinder devices which are provided on the head 172 and which have the same construction as that of the air-operated cylinder devices 112 employed in the pressing and applying head 56. The squeegee 174 is formed of a material such as urethane rubber which has a flexibility, and is elongate in a horizontal, widthwise direction perpendicular to the solder-apply direction. The squeegee 174 is attached to one of two side walls of the housing 176 that are located on both sides of the solder-store room 178 in the solder-apply direction and cooperate with each other to define the store room 178, such that the squeegee 174 is so inclined as to extend downward as it extends in a direction away from the other side wall. A lower end portion of the other side wall of the housing 176 has an inclined surface 182 which is so inclined as to extend downward as it approaches the squeegee 174. A lower end surface of the lower portion of the other side wall provides a horizontal press surface 184 which is continuous with the inclined surface 182 and which is short in the solder-apply direction. The squeegee 174 is attached to the housing 176 such that in a state in which the squeegee head 172 is positioned at its upper dead position and accordingly the head 172 is away from the stencil mask 46, a lower end portion of the squeegee 174 slightly projects downward from the level of the press surface 184.

When the creamed solder 84 is applied to the electric component 20, the substrate 42 and the stencil mask 46 fixed thereto are positioned and fixed at the solder-apply position. The squeegee head 172 is positioned at its upper dead position and at an application-start position which is provided on an upstream side of the substrate 42 and the mask 46 as seen in the solder-apply direction, and where the squeegee 174 is located at an upstream-side end in the direction in which the head 172 is moved to apply the creamed solder 84. From this state, the head 172 is moved downward, so that the press surface 184 and the squeegee 174 are pressed against the mask 46. In this state, the squeegee 174 is elastically deformed as shown in Fig. 9, and the head 172 is moved in a direction indicated at arrow along the stencil mask 46, such that the squeegee 174 is positioned on an upstream side of the press surface 184 as seen in the direction of movement of the head 172. The creamed solder 84 stored in the store room 178 is prevented from coming out of the store room 178 by the press surface 184, and is squeezed against the mask 46 by the squeegee 174, so that the creamed solder 84 is forced into the through-holes 48 and is applied to the electric circuits 44.

When the creamed solder 84 is applied to the substrate 42, the press plate 180 is lowered by the air-operated cylinder devices (not shown) provided on the squeegee head 172. However, a pressing force which the cylinder devices apply to the press plate 180 is smaller than that which the cylinder devices 112 apply to the press plate 98 in the first embodiment shown in Figs. 1 to 6, because in the present embodiment the creamed solder 84 is squeezed against the mask 46 by the squeegee 174 and is thereby forced into the through-holes 48 of the mask 46. The press plate 180 receives, from the cylinder devices, a pressing force which can expel bubbles out of the creamed solder 84 stored in the store room 178 but cannot push the creamed solder 84 out of the store room 178.

After the application of the creamed solder 84, the squeegee head 172 is moved away from the stencil mask 46. Like in the first embodiment shown in Figs. 1 to 6, the two air chambers of each of the two air-operated cylinder devices which cooperate with each other to lower the press plate 180, are both communicated with the atmosphere, and the head 172 is elevated while being moved in the solder-apply direction, so that the head 172 is moved away from the mask 46 without any creamed solder 84 left on the upper surface of the mask 46. After this movement, the head 172 is returned to its application-start position, and waits for applying the creamed solder 84 to another substrate 42. That is, in the present embodiment, the applying device 170 applies the creamed solder 84 only when being moved in the predetermined one direction. The electric component 20 is conveyed to the infrared-light heating furnace 120, and is heated by the same 120, so that the creamed solder 84 present in the through-holes 48 is melted and solder bumps 144 are formed on the electric circuits 44 of the substrate 42.

Fig. 10 shows a fourth embodiment of the present invention that relates to a solder-bump forming apparatus which employs a squeegee for moving creamed solder placed on a mask and thereby filling through-holes of the mask with the creamed solder and which heats the creamed solder present in the through-holes concurrently with the application of the creamed solder. The following description relates to a case where the present apparatus is used for forming solder bumps on the substrate 42 as part of the leadless electric component 20 shown in Fig. 3.

In the present embodiment, the electric component 20 having the substrate 42 is fitted in a positioning hole 192 formed in a holding member 190, and is accurately positioned by the same 190. In the present embodiment, the holding member 190 provides the positioning device. The holding member 190 is conveyed by a substrate moving device 194 which is provided by a belt conveyor which includes a pair of conveyor belts 196 in the form of V-belts, a belt drive device (not shown) for moving the belts 196, and a positioning and fixing device (not shown) for positioning the holding member 190 relative to the belts 196 and fixing the member 190 to the same 196. At the solder-apply position, there is provided a positioning and fixing device (not shown) which accurately positions the holding member 190 or the electric component 20 (i.e., the substrate 42) at the solder-apply position, and accurately fixes the substrate 42 at the same position.

At the solder-apply position, a stencil mask 200 similar to the stencil mask 46 is provided such that the mask 200 is vertically movable toward, and away from, the substrate 42 positioned and fixed at the solder-apply position. Like the mask 46, the mask 200 has a plurality of through-holes (not shown) at respective positions corresponding to the electric circuits 44 provided on the substrate 42. The through-holes are formed through the thickness of the mask 200. The mask 200 is supported by a frame 202 which is vertically moved, by an elevating and lowering device (not shown) as a mask moving device, to an operative position where the mask 200 is superposed on the substrate 42 positioned and fixed at the solder-apply position, and to an inoperative position, away from the operative position, where the mask 200 is spaced from the substrate 42 and allows the substrate 42 to be moved to, and from, the solder-apply position. A position of the mask 200 on a horizontal plane parallel to the upper surface of the substrate 42 positioned at the solder-apply position, on which surface the electric circuits 44 are provided, is adjustable and, in fact, is adjusted by a position adjusting device (not shown) so that the mask 200 is superposed on the substrate 42 such that the through-holes of the mask 46 are aligned with the electric circuits 44 of the substrate 42. In the present embodiment, the position adjusting device provides the positioning device which positions the stencil mask 200 relative to the substrate 42 of the electric component 20. The position and fixing device which positions and fixes the holding member 190 relative to the conveyor belts 196, and the position and fixing device which positions and fixes the holding member 190 at the solder-apply position, and the position adjusting device which adjusts the position of the stencil mask 200 are all well known in the art, and accordingly the description and illustration thereof are omitted.

An applying device 206 and a heating device 208 are provided above the stencil mask 200, and are moved by a moving device 209 provided at the solder-apply position. The moving device 209 includes a movable member 210 which is movable in opposite directions parallel to the substrate-convey direction, and a movable-member moving device 212 which moves the movable member 210 and which includes a servomotor 214 as its drive source. The rotation of the servomotor 214 is converted into linear motion of the movable member 210 by a ball screw 216 and a nut (not shown), and the movable member 210 is moved by being guided by a guide device 220 including a pair of guide rails 218.

Two squeegees 224, 226 are supported by an intermediate portion of the movable member 210 as seen in the direction of movement thereof. The two squeegees 224, 226 are held by two squeegee holders 228, 230, respectively, and are elevated and lowered by two air-operated cylinder devices 232, 234, respectively, so as to be moved toward and away from the substrate 42 and the stencil mask 200. The two squeegees 224, 226 are elongate in a horizontal, widthwise direction perpendicular to the substrate-convey direction and parallel to the upper surface of the substrate 42, and are so inclined as to approach each other as they extend upward. The heating device 208 includes two laser-beam emitting devices 236, 238 which are provided on both sides of the squeegees 224, 226 as seen in the direction of movement of the movable member 210, respectively. Each of the two laser-beam emitting devices 236, 238 is elongate in the above-indicated widthwise direction like each squeegee 224, 226, and accordingly emits a laser beam toward respective portions of the stencil mask 200 and the substrate 42 that are elongate in the widthwise direction. The applying device 206 and the heating device 208 are accurately provided, in the widthwise direction, at a position where the applying device 206 can apply the creamed solder 84 to each portion of the substrate 42 positioned at the solder-apply position and the heating device 208 can heat each portion of the substrate 42. When the movable member 210 is moved by the movable-member moving device 212, the applying device 206 and the heating device 208 are moved along the substrate 42. Thus, the applying device 206 and the heating device 208 share the moving device 209. In addition, the present apparatus can be said to have two applying devices and two heating devices. The applying device 206 and the heating device 208 may be moved by two moving devices, respectively. The first combination of above-indicated two applying devices and the second combination of above- indicated two heating devices may be moved by two moving devices, respectively, or the two heating devices and the two heating devices may be moved by four moving devices, respectively. The present solder-bump forming apparatus is controlled by a control device 240 which is essentially provided by a computer.

When the creamed solder 84 is applied to the substrate 42, the holding member 190 holding the electric component 20 is placed on the conveyor belts 196 and is moved by the belts 196 in a direction indicated arrow in Fig. 10 toward the solder-apply position. At this time, the two squeegees 224, 226 are positioned at their upper dead positions, and the stencil mask 200 is positioned at its upper, inoperative position, so that the electric component 20 is allowed to move to the solder-apply position. After the electric component 20 is positioned and fixed at the solder-apply position, the stencil mask 200 is lowered and is superposed on the substrate 42 of the component 20.

Then, one of the two squeegees 224, 226 that is located on an upstream side of the other squeegee as seen in the direction of movement of the applying device 206 to apply the creamed solder 84 to the substrate 42, is lowered and is pressed against the stencil mask 200 such that the one squeegee is elastically deformed. Regarding the example shown in Fig. 10, when the applying device 206 is moved in a direction indicated at arrow, the squeegee 224 is lowered and pressed against the mask 200. On the mask 200, there is the creamed solder 84, and the squeegee 224 is moved on the upper surface of the mask 200 while being pressed on the upper surface of the mask 200, so that the squeegee 224 squeezes the creamed solder 84 against the mask 200 and thereby fills the through-holes 48 with the creamed solder 84. Thus, the creamed solder 84 is applied to the electric circuits 44 of the substrate 42. Concurrently with the printing of the creamed solder 84, one of the two laser-beam emitting devices 236, 238 that is located on an upstream side of the one squeegee as seen in the direction of movement of the applying device 206, is operated by the control device 240 to emit or irradiate a laser beam toward the electric component 20 and the stencil mask 200 superposed thereon, so that the creamed solder 84 present in the through-holes 48 of the mask 46 is melted and solder bumps are formed on the electric circuits 44 of the substrate 42. Thus, the solder-apply position is also a solder-heat position.

After the one squeegee reaches the downstream-side end of the upper surface of the stencil mask 200 superposed on the substrate 42 and finishes the application of the creamed solder 84 to the substrate 42, the movable member 210 is further moved so that the one laser-beam emitting device can heat all the creamed solder 84 applied to the substrate 42. When the one emitting device reaches the downstream-side end of the mask 200, the operations of the heating device 208 and the moving device 209 are stopped. The holding member 190 and the stencil mask 200 are elongate in the solder-apply direction, and have, on both sides of the electric component 20 in the same direction, respective margins each of which allows the one squeegee to be moved till the end of the heating of the one laser-beam emitting device after the end of the application of the creamed solder 84 by the one squeegee.

After the end of the heating, the one squeegee which has been used to apply the creamed solder 84 to the substrate 42 is elevated to its upper dead position and the stencil mask 200 is also elevated away from the substrate 42. Subsequently, the electric component 20 on which the solder bumps have been formed is carried out by the conveyor belts 196 in the state in which the component 20 is held by the holding member 190. When the creamed solder 84 is applied to another substrate 42, the other squeegee and the other laser-beam emitting device that have been waiting are used to apply and heat the creamed solder 84. However, the other squeegee and the other emitting device are moved in a direction opposite to the direction in which the one squeegee and the one emitting device are moved to form the solder bumps on the first substrate 42. Since the two squeegees 224, 226 are employed and are alternately used to apply the creamed solder 84 to a plurality of substrates 42, it is not needed to return the applying device 206 to an application-start position after the creamed solder 84 is applied to each one substrate 42. Thus, the creamed solder 84 can be quickly applied to the substrates 42 and the efficiency of application of the creamed solder 84 is improved.

In each of the first to third embodiments shown in Figs. 1 to 9, the second belt conveyor 14 is moved at the same speed as that at which the first belt conveyor 12 is moved to convey the electric component 20. However, the two conveyors 12, 14 are required to be moved at the same speed around a time when the component 20 is transferred from the first conveyor belts 16 to the second conveyor belts 30. Since the application, and heating, of the creamed solder 84 are carried out at the different positions and the different belt conveyors 12, 14 are employed to convey each electric component 20, the respective speeds at which the two conveyors 12, 14 are moved to convey each component 20 can be controlled or changed to respective desired speeds by the control device 140. For example, the speed at which the component 20 is moved toward the heating-furnace-side end of the conveyor belts 16 may be controlled to differ from that at which the component 20 is moved after being transferred to the conveyor belts 30 and before entering the infrared-light heating furnace 120. In addition, each electric component 20 may be heated while being continuously moved without being stopped.

Between the first and second belt conveyors 12, 14, there may be provided a substrate transferring device or a substrate pushing device which transfers each electric component 20 which has reached the heating-furnace-side end of the first conveyor 12, to the second conveyor 14.

In each of the first to third embodiments shown in Figs. 1 to 9 wherein the application, and heating, of the creamed solder 84 are carried out at the different positions, the two belt conveyors 12, 14 may be replaced with a single belt conveyor.

In each of the first to fourth embodiments shown in Figs. 1 to 10, each of the belt conveyors 12, 14, 194 includes the two conveyor belts 16, 30, 196. However, the two conveyor belts 16, 20, 196 may be replaced with a single conveyor belt. In this case, the single belt has a width which assures that the belt can position and support each substrate.

In each of the illustrated embodiments, the substrate conveying device 10, 194 is provided by one or more belt conveyors 12, 14, 196. However, the substrate conveying device 10, 194 may be provided by a different sort of conveyor that includes a wound-on member and a wound-on-member drive device for moving the wound-on member and thereby conveying the substrate 42, 150 placed on the wound-on member.

In addition, the substrate conveying device 10, 194 is provided by one or more belt conveyors 12, 14, 196 each of which conveys the substrate 42, 150 while directly supporting the same 42, 150 thereon. However, the substrate conveying device 10, 194 may be one which includes a substrate support member, such as a pallet, for directly supporting the substrate 42, 150 thereon, and a substrate-support-member drive device for moving the substrate support member and thereby conveying the substrate 42, 150. In the latter case, the substrate 42, 150 is positioned relative to the substrate support member, which in turn is positioned relative to the substrate-support-member drive device.

In each of the third and fourth embodiments shown in Figs. 8 to 10, the solder-bump forming apparatus may be used for forming solder bumps on the printed wiring board 150 as the substrate.

Each feature disclosed in this specification (which term includes the claims) and/or shown in the drawings may be incorporated in the invention independently of other disclosed and/or illustrated features.

Statements in this specification of the "objects of the invention" relate to preferred embodiments of the invention, but not necessarily to all embodiments of the invention falling within the claims.

The description of the invention with reference to the drawings is by way of example only.

The text of the abstract filed herewith is repeated here as part of the specification.

A method of forming one or more solder bumps, including the steps of superposing a mask having one or more through-holes on a substrate having one or more electric circuits, filling the through-holes with creamed solder to apply the creamed solder to the electric circuits, heating the substrate and the mask superposed thereon to form the creamed solder in the one or more through-holes into one or more solder bumps, and removing the mask from the substrate having the solder bump.

## Claims

1. A method of forming at least one solder bump on a substrate, comprising the steps of:
positioning a mask having at least one through-hole over a substrate,
filling the or each through-hole with a creamed solder to apply the creamed solder to the substrate, and
heating the substrate and the mask to form the creamed solder into at least one solder bump on the substrate, and removing the mask from over the substrate following formation of said at least one solder bump.

2. A method according to Claim 1, wherein the substrate has an electric circuit formed thereon, said solder bump being formed on the electric circuit.

3. A method according to Claim 1 or 2, wherein the step of filling the through-hole comprises moving the creamed solder over a surface of the mask while pressing the creamed solder against said surface of the mask to thereby fill the through-hole with the creamed solder.

4. A method according to Claim 1 or 2, wherein the step of filling the through-hole comprises placing the creamed solder on the mask, and moving a squeegee over the mask to squeeze the creamed solder into the through-hole of the mask, and thereby fill the through-hole with the creamed solder.

5. A method according to any one of Claims 1 to 4, wherein the step of heating the substrate and the mask comprises placing the substrate and the mask positioned thereover in a heating furnace, and heating the substrate and the mask in the heating furnace.

6. A method according to any one of Claims 1 to 4, wherein the step of heating the substrate and the mask comprises irradiating an electromagnetic wave toward at least the through-bole of the mask positioned over the substrate, thereby melting the creamed solder in the through-hole.

7. A method according to any one of Claims 1 to 6, wherein the mask is formed of a material which has a lower wettability with respect to the creamed solder than a wettability of the substrate with respect to the creamed solder.

8. Apparatus for forming at least one solder bump (144), comprising:
means (50) for positioning a mask (46/154/200) having at least one through-hole (48/156), over a substrate (42/150);
means (54/170/206) for filling the through-hole of the mask with a creamed solder (84) to apply the creamed solder to the substrate; and
means (120/208) for heating at least the creamed solder in the through-hole of the mask while the mask is positioned over the substrate to form at least one solder bump on the substrate.
